# EUROPEAN PATENT APPLICATION

(11) **EP 4 303 930 A1**
(43) Date of publication of application: **10.01.2024**
(21) Application number: 22183833.7
(22) Date of filing: 08.07.2022
(51) Int. Cl.: H01L 27/1159, H01L 49/02, H01L 27/11507

(54) **A LAYER STACK FOR A FERROELECTRIC DEVICE**

(71) Applicant: Imec VZW, 3001 Leuven (BE)
(72) Inventor: Popovici, Mihaela Ioana, 3001 Leuven (BE); Bizindavyi, Jasper, 3001 Leuven (BE); Van Houdt, Jan, 3001 Leuven (BE); Delhougne, Romain, 3001 Leuven (BE)
(74) Representative: Roth, Sebastian

(57) **Abstract**

The present disclosure relates to ferroelectric devices. The disclosure proposes a ferroelectric device including a new kind of layer stack and a method for fabricating the ferroelectric device. In particular, the ferroelectric device comprises a first electrode and a second electrode, and the layer stack arranged between the first electrode and the second electrode. The layer stack comprises a titanium oxide layer, a doped HZO layer arranged on the titanium oxide layer, and a niobium oxide layer arranged on the doped HZO layer.

## Description

### TECHNICAL FIELD

The present disclosure relates to a ferroelectric device, for example, to a metal-ferroelectric-metal (MFM) capacitor, a ferroelectric random access memory (FERAM), or a ferroelectric field effect transistor (FEFET). The disclosure proposes a new kind of layer stack for such a ferroelectric device, and particularly presents a ferroelectric device including the layer stack, and a method for fabricating the ferroelectric device.

### BACKGROUND

In the last years, numerous scientific publications and inventions demonstrated high endurance MFM capacitors for FERAM, and metal ferroelectric insulator semiconductor (MFIS) stacks for FEFET, all based on hafnium zirconate (HZO). The main challenges of such ferroelectric devices, particularly memories, based on HZO are a prolonged wake-up effect and an only modest initial remnant polarization.

A reduction of the wake-up effect may be achieved by a suitable selection of the electrodes of the HZO-based ferroelectric device - for example, electrodes made of tungsten (W), tungsten nitride (WN), or molybdenum (Mo). However, the endurance of the ferroelectric device is reduced to only about 1E+5 to 1E+7 cycles.

On the other hand, an increased endurance of up to 1E+11 cycles and beyond can be achieved for the HZO-based ferroelectric device by using titanium nitride (TiN) electrodes - which are more easily accessible for CMOS integration and are associated with lower costs. However, the ferroelectric device shows a prolonged wake-up effect and a more modest remnant polarization.

### SUMMARY

In view of the above, an objective of this disclosure is to provide a HZO-based ferroelectric device, which shows a higher remnant polarization, a reduced wake-up effect, and an improved endurance - all at the same time. In addition, a low cost device and the possibility to integrate with CMOS are other objectives of this disclosure.

These and other objectives are achieved by the solutions provided in the independent claims. Advantageous implementations are defined in the dependent claims.

Generally, this disclosure is based on the understanding that a depinning of domains and their favorable orientation with respect to the applied electrical field, as well as a stabilization of the orthorhombic phase on the expense of the tetragonal one, and suppression of non-ferroelectric phases (cubic and monoclinic) formation, may be key factors to achieve a larger remnant polarization in a longer range.

This disclosure is also based on the insight that lanthanides and rare-earth doped HZO, which are ferroelectric materials with high endurance (e.g., >1E+10 cycles), may suffer from modest initial polarization. For example, between 1E+5 and 1E+7 switching cycles may be needed to reach the maximum remnant polarization.

A first aspect of this disclosure provides a ferroelectric device comprising: a first electrode and a second electrode; a layer stack arranged between the first electrode and the second electrode, wherein the layer stack comprises a titanium oxide layer, a doped HZO layer arranged on the titanium oxide layer, and a niobium oxide layer arranged on the doped HZO layer.

Accordingly, this disclosure proposes a new kind of layer stack that has at least three layers, which include titanium oxide as a seed layer for the doped HZO layer, and niobium oxide as a cap layer on the doped HZO layer. This layer stack leads to a reduced wake-up effect and an increased remnant polarization, while an endurance above 1E+10 cycles is achieved at the same time.

In particular, the titanium oxide layer provokes a change of the ratio of orthorhombic **(002)** oriented grains to orthorhombic **(111)** oriented grains in the doped HZO layer, and thus the doped HZO will comprise grains containing orthorhombic phase with a having a favorable orientation of the polar domains with respect to the applied electrical field. Further, this may achieve a stabilization of the orthorhombic phase on the expense of the tetragonal one. This may further lead to a larger remnant polarization, both initial and maximum. The addition of the niobium oxide layer further increases the remnant polarization, and reduces the wake-up effect.

According to an implementation form of the ferroelectric device, the first electrode and the second electrode comprise at least a titanium nitride (TiN) layer.

The TiN layers may be the layers of the electrodes that are in direct contact with the layer stack. However, this does not exclude other layers, which may be arranged under the TiN layer of the first electrode, or may be arranged above the TiN layer of the second electrode. For instance, other metal layers could be included in the electrodes, for example, metal layers made of W and/or tantalum nitride (TaN). Other metal combinations of outer electrode layers could also include W and/or ruthenium (Ru) and/or TaN. Atomic layer deposition (ALD) may be used to manufacture both the first electrode and the second electrode, or to manufacture at least one of the two electrodes. TiN electrodes may reduce device cost, and may facilitate the possibility to integrate the ferroelectric device and its fabrication with CMOS.

According to an implementation form of the ferroelectric device, the titanium oxide layer is a titanium dioxide (TiO₂) layer and the niobium oxide layer is a niobium pentoxide (Nb2O₅) layer.

High remnant polarization, high endurance, and a low wake-up effect are achieved with the TiO₂ layer as a seed layer for the doped HZO layer, and with the Nb2O₅ layer as a cap layer of the doped HZO.

According to an implementation form of the ferroelectric device, the titanium oxide layer has a layer thickness in a range of 0.5-2.5 nm.

According to an implementation form of the ferroelectric device, the doped HZO layer is doped at least with lanthanum (La) and/or other lanthanides such as praseodymium (Pr), cerium (Ce), gadolinium (Gd), and/or rare earth metals such as yttrium (Y) or scandium (Sc).

According to an implementation form of the ferroelectric device, the doped HZO layer comprises a ratio of orthorhombic **(002)** oriented grains to orthorhombic **(111)** oriented grains that is equal to or larger than 0.8.

This may further increase the remnant polarization achievable for the ferroelectric device.

According to an implementation form of the ferroelectric device, the layer stack consists of the titanium oxide layer, the doped HZO layer, and the niobium oxide layer; or the layer stack further comprises a tungsten trioxide (WO₃) layer arranged on the niobium oxide layer.

These two alternatives have both shown very good results concerning the increase of the remnant polarization and endurance, while suppressing the wake-up effect.

According to an implementation form of the ferroelectric device, the doped HZO layer is a ferroelectric layer and has at least two non-zero remnant polarization charge states.

According to an implementation form of the ferroelectric device, a remnant polarization of the doped HZO layer is at least 15-60 µC/cm² and an endurance of the doped HZO layer is equal to or greater than 1E+8 cycles.

According to an implementation form of the ferroelectric device, the ferroelectric device is a metal-ferroelectric-metal capacitor; and/or the ferroelectric device is a ferroelectric random access memory; and/or the ferroelectric device is a ferroelectric field effect transistor.

A second aspect of this disclosure provides a method for fabricating a ferroelectric device, the method comprising steps of: forming a first electrode; forming a layer stack on the first electrode, wherein forming the layer stack comprises forming a titanium oxide layer, forming a doped hafnium zirconate, HZO, layer on the titanium oxide layer, and forming a niobium oxide layer on the doped HZO layer; and forming a second electrode on the layer stack.

The method of the second aspect achieves the same advantages as described above for the ferroelectric device of the first aspect. In particular, the method of the second aspect fabricates a ferroelectric device with a high remnant polarization, a reduced wake-up effect, and a high endurance.

According to an implementation form, the method further comprises an oxygen plasma exposure step or an ozone exposure step after the step of forming the doped HZO layer and before the step of forming the niobium oxide layer.

The oxygen plasma exposure or the ozone exposure further improves the endurance of the ferroelectric device, which is produced with the method of the second aspect.

According to an implementation form of the method, at least one of the titanium oxide layer, the first electrode, and the second electrode, is formed by atomic layer deposition (ALD).

According to an implementation form of the method, the titanium oxide layer, the first electrode, and the second electrode, are formed by atomic layer deposition (ALD), which advantageously allows conformal growth of the layers in 3D structures such as 3D metal-ferroelectric-metal capacitors, and/or ferroelectric random access memories, and/or ferroelectric field effect transistors.

According to an implementation form of the method, the titanium oxide layer is formed by atomic layer deposition using titanium methoxide and water.

This process may ensure the change in the preferential grain orientation of the doped HZO layer towards orthorhombic **(002).** In consequence, the remnant polarization may be boosted over 24 µC/cm² already from the start of endurance cycling, because more grains have preferential orientation with respect to the applied electric field.

According to an implementation form, the method further comprises an anneal step at a temperature above 375°C after the step of forming the second electrode.

This may facilitate transitions from the tetragonal phase to the polar orthorhombic phase.

Notably, in the claims as well as in the description of this disclosure, the word "comprising" does not exclude other elements or steps and the indefinite article "a" or "an" does not exclude a plurality.

### BRIEF DESCRIPTION OF THE DRAWINGS

The above described aspects and implementations are explained in the following description of embodiments with respect to the enclosed drawings:
- FIG. 1: shows a ferroelectric device according to this disclosure.
- FIG. 2: shows another ferroelectric device according to this disclosure.
- FIG. 3: shows a method for fabricating a ferroelectric device, according to this disclosure.
- FIG. 4: shows optional details of the method of FIG. 3
- FIG. 5: shows polarization-electric field loops in (a), and shows remnant polarization vs. the number of switching cycles in (b), for a ferroelectric device according to this disclosure.
- FIG. 6: shows grazing incidence X-ray diffraction results for a reference ferroelectric device with only a doped HZO layer, and for a ferroelectric device according to this disclosure, and for a ferroelectric device according to this disclosure particularly produced with an additional oxygen plasma or ozone exposure step as shown in FIG. 4.
- FIG. 7: shows a transmission electron microscopy (TEM) image in (a), and an energy dispersive spectroscopy (EDS) chemical depth profile in (b), for a ferroelectric device according to this disclosure.

### DETAILED DESCRIPTION OF EMBODIMENTS

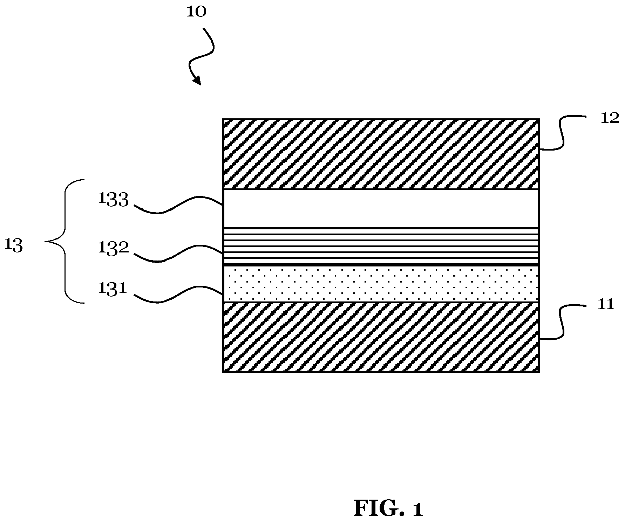

FIG. 1 shows a ferroelectric device 10 according to this disclosure. The ferroelectric device 10 may be, or may comprise, at least one of a MFM capacitor, a FERAM, and a FEFET. The ferroelectric device 10 may be at least suitable to fabricate such a MFM capacitor, or FERAM, or FEFET. The ferroelectric device 10 of this disclosure is designed based on a new kind of layer stack 13 inserted between the two electrodes 11 and 12, wherein the layer stack 13 includes at least three layers, but may also include more than three layers, as described in the following.

The ferroelectric device 10 shown in FIG. 1 comprises a first electrode 11 and a second electrode 12, which sandwich the layer stack 13. The first electrode 11 and the second electrode 12 may comprise each at least one TiN layer. This TiN layer of either electrode 11, 12 may be in direct contact with the layer stack 13. For example, either electrode 11, 12 may also be made completely of TiN.

The layer stack 13 of the ferroelectric device 10 is arranged between the first electrode 11 and the second electrode 12. The layer stack 13 comprises at least a titanium oxide layer 131 (e.g., a TiO₂ layer), a doped HZO layer 132 (e.g., a lanthanum (La)-doped HZO layer, also referred to as La:HZO layer) arranged on the titanium oxide layer 131, and a niobium oxide layer 133 (e.g., an Nb2O₅ layer) arranged on the doped HZO layer 132.

The titanium oxide layer 131 may have a layer thickness in a range of 0.5-2.5 nm. The doped HZO layer may alternatively or additionally to the La-doping also be doped with at least one of Pr, Ce, Gd, Y, Sc, or another rare earth metal.

As shown exemplarily in FIG. 1, the titanium oxide layer 131 may be directly arranged on the first electrode 11, and the second electrode 12 may be directly arranged on the niobium oxide layer 133. Thus, the layer stack 13 may consist of the titanium oxide layer 131, the doped HZO layer 132, and the niobium oxide layer 133, as illustrated.

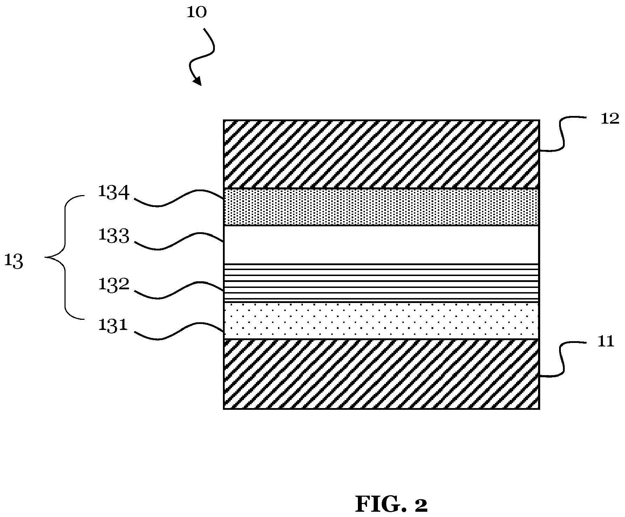

As shown in FIG. 2, alternatively, the layer stack 13 may further comprise an additional layer 134, e.g., a tungsten trioxide layer 134, which is arranged on the niobium oxide layer 133. In this case, the layer stack 13 may consist of the titanium oxide layer 131, the doped HZO layer 132, the niobium oxide layer 133, and the tungsten trioxide layer 134, as illustrated. The second electrode 12 may in this case be arranged on this additional layer, e.g., the tungsten trioxide layer 134. The layer stack 13 may generally comprise three layers or four layers, or even more layers.

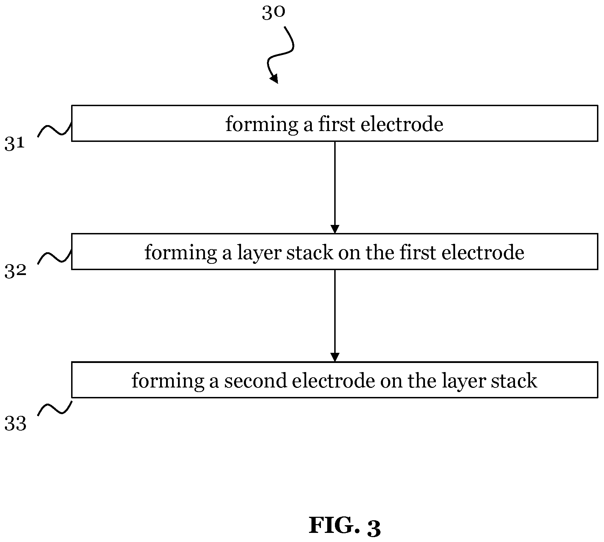

FIG. 3 shows a flow diagram of a general method 30 that can be used to fabricate the ferroelectric device 10 shown in FIG. 1. The method 30 comprises a step 31 of forming the first electrode 11, a step 32 of forming the layer stack 13 on the first electrode 11, and a step 33 of forming the second electrode 12 on the layer stack 13. The first electrode 11 and the second electrode 12 may each be formed by ALD, for instance, of a TiN material or with at least one layer of TiN. The layer stack 13 may be also formed by ALD.

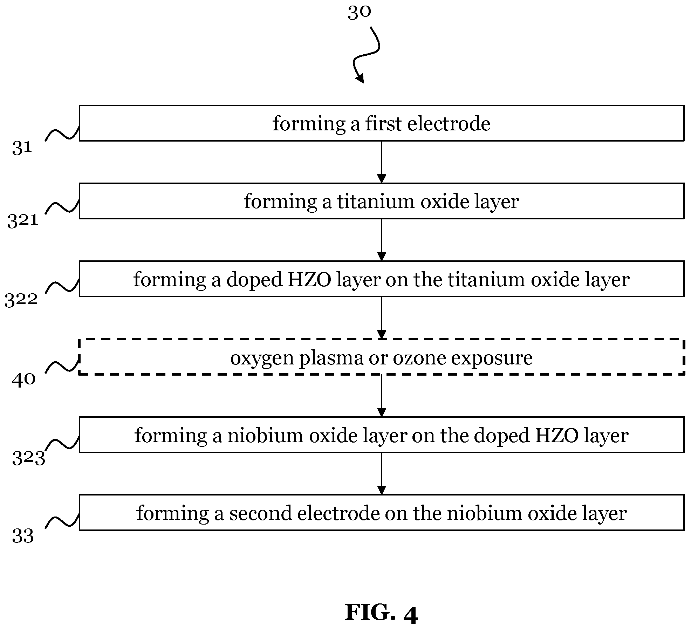

As shown in FIG. 4, the step 32 of forming the layer stack comprises at least a step 321 of forming the titanium oxide layer 131, a step 322 of forming the doped HZO layer 132 on the titanium oxide layer 131, and a step 323 of forming the niobium oxide layer 133 on the doped HZO layer.

In addition, in order to reach the ferroelectric device 10 shown in FIG. 2, the method 30 may further comprise an optional step of forming the additional layer 134, e.g., the tungsten trioxide layer 134. Of the layers of the layer stack 13, at least the titanium oxide layer 131 may be formed by ALD. However, also the other layers of the layer stack may respectively be formed by ALD.

FIG. 4 also shows an optional step 40, which may be carried out between step 322 of forming the doped HZO layer 132 and step 323 of forming the niobium oxide layer 133. The optional step 40 comprises, or consists of, an oxygen plasma exposure or an ozone exposure step, wherein the ferroelectric device 10, as fabricated up to step 322, is exposed to an oxygen plasma or an ozone treatment. Optionally, after the step 33 also an anneal step maybe added to the method 30, wherein the ferroelectric device 10 may be annealed at a temperature above 375°C.

In summary of the above, this disclosure presents the use of a new kind of tri-layer stack (shown in FIG. 1) or four-layer stack (shown in FIG. 2) for a ferroelectric device 10. For example, the layer stack may comprise a TiO₂ layer 131 as a seed layer for a La-doped HZO layer 132, and an Nb2O₅ layer 133 as a cap layer on the La-doped HZO layer 132. When using such a layer stack 13, the wake-up effect of the ferroelectric device 10 - compared to a conventional ferroelectric device such as with only a doped-HZO layer between the electrodes - may be strongly suppressed. At the same time also the remnant polarization (2Pr) of the ferroelectric device 10 may be increased, and an endurance above 1E+10 cycles may be achieved.

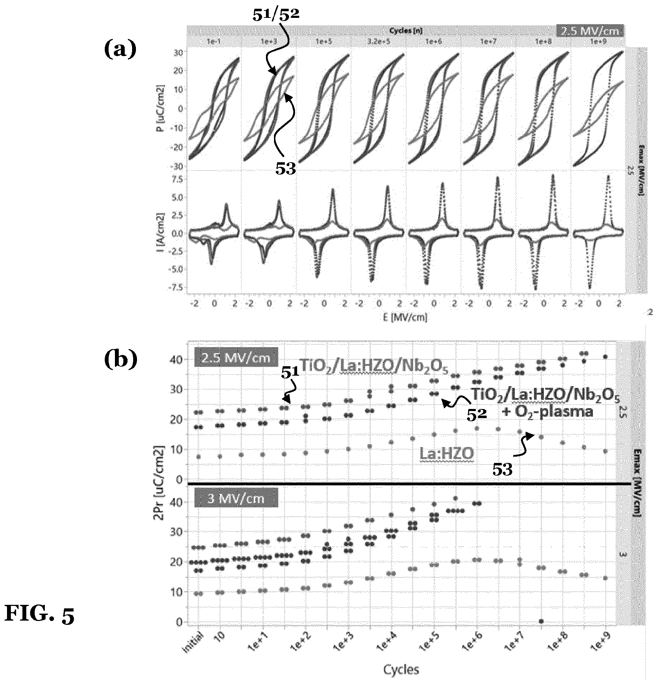

For example, as demonstrated in FIG. 5, a MFM capacitor (as the ferroelectric device 10) including a tri-layer stack consisting of the TiO₂ seed layer 131, the La-doped HZO, layer 132 and the Nb2O₅ cap layer 133, shows a significant increase (see the data set 51) in both the initial remnant polarization (>17 µC/cm²) and the maximum remnant polarization (>40 µC/cm²) for an electrical field of 2.5 MV/cm applied across the layer stack using the first electrode 11 and the second electrode 12, without signs of fatigue even at 1E+9 cycles. This is compared in FIG. 5 to a MFM capacitor with only a La-doped HZO layer (see data set 53). Notably, higher remnant polarizations are even possible at higher electric fields, for instance, of 3 MV/cm, but thus may come at a slight cost of endurance.

A further way to improve the endurance of the ferroelectric device 10 is to apply the above-described oxygen plasma exposure step 40 during the fabrication method 30, in particular, exposing the La-doped HZO layer 132 to the oxygen plasma. The insertion of the oxygen plasma exposure 40, after the La-doped HZO layer 132 is grown on the TiO₂ seed layer 131 and before the Nb2O₅ cap layer 133 is added onto the doped HZO layer 132, results in an endurance near 1E+11 cycles at an electrical field of 2 MV/cm, as shown in FIG. 5 (see the data set 52). This was notably achieved together with an initial polarization of 15 µC/cm² and a maximum polarization of > 40 µC/cm² without signs of fatigue.

In order to maintain the neutrality of the doped HZO layer 132 (containing tetravalent Hf4+ and Zr4+ ions), oxygen vacancies are induced when doping, for instance, with trivalent La3+ dopants. In the early growth stages during an ALD process used to grow the doped HZO layer 132, the tetragonal phase (t-phase) is predominantly formed and transitions to the polar orthorhombic phase (o-phase) are assumed to mainly take place later during the annealing step. Applying the oxygen plasma step 40 before the annealing step may affect the level of oxygen vacancies formed in the La-doped HZO layer 132, and may consequently affect the relative tetragonal/orthorhombic phase ratio, which is reflected in differences observed in remnant polarization.

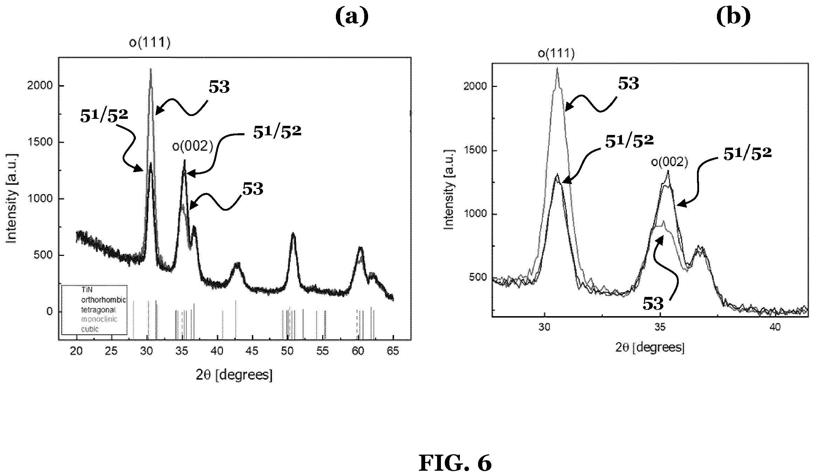

FIG. 6 shows X-ray diffraction spectra of the ferroelectric device 10, which were taken after 10 nm of TiN were deposited as second electrode 12, and a 550 °C and 1 min N2 crystallization anneal was performed. A reduction of the main peak orthorhombic **(111)** was observed, while the grains with preferential orientation along out-of-plane orthorhombic **(002)** reflection are strongly increased for the case where the TiO₂ seed layer 131 was used. FIG. 6(a), and the zoom in shown in FIG. 6(b), demonstrate this for both cases, i.e., for the case with oxygen exposure step 40 (see the data set 52) and for the case without the oxygen exposure step 40 (see the data set 51). For example, the doped HZO layer 132 of the ferroelectric device 10 may comprise a ratio of orthorhombic **(002)** oriented grains to orthorhombic **(111)** oriented grains that is equal to or larger than 0.8. This is compared in FIG. 6 with a conventional La-doped HZO layer between the electrodes tack (see the data set 53).

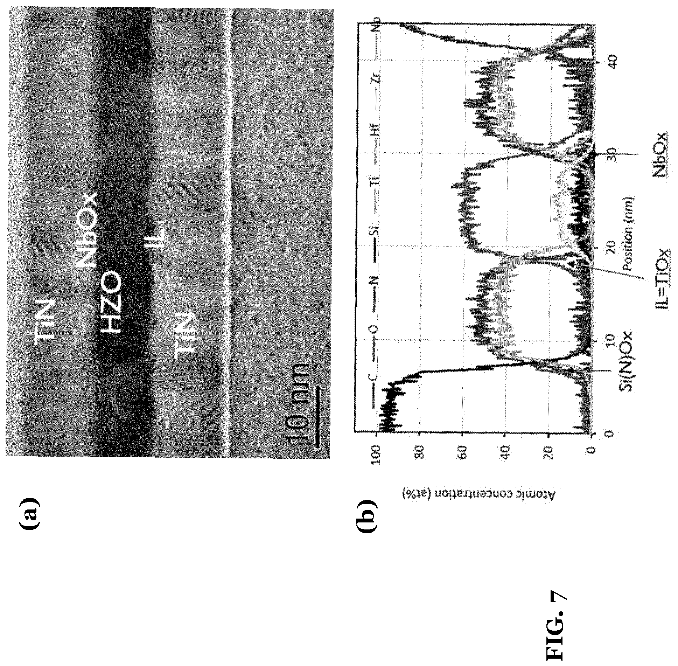

FIG. 7 shows in (a) an X-TEM image, and in (b) an EDS chemical depth profile for the ferroelectric device 10, which comprises first and second TiN electrodes 11, 12, and a tri-layer stack of TiO₂ La-doped HZO, and Nb2O₅. It can be seen that the layers of ferroelectric device 10 are well crystallized, and that no diffusion of Ti or Nb into the doped HZO layer 132 can be put in evidence by the EDS.

To conclude the above, according to this disclosure, the insertion of a titanium oxide layer 131 (e.g., a thin 1 nm TiO₂ layer that is grown by ALD) between the bottom electrode 11 and the doped HZO layer 132, may lead to a change in the preferential orientation of the grains with orthorhombic **(002)** reflection surpassing in intensity the orthorhombic **(111)** main reflection, which appears in randomly-oriented doped HZO grains. Further, the addition of the niobium oxide layer 133 (e.g., an Nb2O₅ cap layer on the doped HZO layer 132) supplies a boost in remnant polarization and, importantly, a reduction of the wake-up effect.

The combination of the doped HZO layer 132 with the two interfacial layers 131 and 133 (e.g., TiO₂ and Nb₂O₅) - as proposed in this disclosure - is able to circumvent the wake-up problem, and boosts the remnant polarization even above the values reached with the bi-layer stacks.

## Claims

1. A ferroelectric device (10) comprising:
a first electrode (11) and a second electrode (12);
a layer stack (13) arranged between the first electrode (11) and the second electrode (12),
wherein the layer stack (13) comprises a titanium oxide layer (131), a doped hafnium zirconate, HZO, layer (132) arranged on the titanium oxide layer (131), and a niobium oxide layer (133) arranged on the doped HZO layer (132).

2. The ferroelectric device (10) according to claim 1, wherein the first electrode (11) and the second electrode (12) comprise at least a titanium nitride layer.

3. The ferroelectric device (10) according to claim 1 or 2, wherein the titanium oxide layer (131) is a titanium dioxide layer and the niobium oxide layer (133) is a niobium pentoxide layer.

4. The ferroelectric device (10) according to one of the claims 1 to 3, wherein the titanium oxide layer (131) has a layer thickness in a range of 0.5-2.5 nm.

5. The ferroelectric device (10) according to one of the claims 1 to 4, wherein the doped HZO layer (132) is doped at least with lanthanum and/or other lanthanides such as praseodymium, cerium, gadolinium, and/or rare earth metals such as yttrium or scandium.

6. The ferroelectric device (10) according to one of the claims 1 to 5, wherein the doped HZO layer (132) comprises a ratio of orthorhombic **(002)** oriented grains to orthorhombic **(111)** oriented grains that is equal to or larger than 0.8.

7. The ferroelectric device (10) according to one of the claims 1 to 6, wherein:
the layer stack (13) consists of the titanium oxide layer (131), the doped HZO layer (132), and the niobium oxide layer (133), or
the layer stack (13) further comprises a tungsten trioxide layer (134) arranged on the niobium oxide layer (133).

8. The ferroelectric device (10) according to one of the claims 1 to 7, wherein the doped HZO layer (132) is a ferroelectric layer (10) and has at least two non-zero remnant polarization charge states.

9. The ferroelectric device (10) according to one of the claims 1 to 8, wherein a remnant polarization of the doped HZO layer (132) is at least 15-60 µC/cm² and an endurance of the doped HZO layer (132) is equal to or greater than 1E+8 cycles.

10. The ferroelectric device (10) according to one of the claims 1 to 9, wherein:
the ferroelectric device (10) is a metal-ferroelectric-metal capacitor; and/or
the ferroelectric device (10) is a ferroelectric random access memory; and/or
the ferroelectric device (10) is a ferroelectric field effect transistor.

11. A method (30) for fabricating a ferroelectric device (10), the method (30) comprising steps of:
forming (31) a first electrode (11);
forming (32) a layer stack (13) on the first electrode (11);
wherein forming (32) the layer stack (13) comprises forming (321) a titanium oxide layer (131), forming (322) a doped hafnium zirconate, HZO, layer (132) on the titanium oxide layer (131), and forming (323) a niobium oxide layer (133) on the doped HZO layer (132); and
forming (33) a second electrode (12) on the layer stack (13).

12. The method (30) according to claim 11, further comprising an oxygen plasma exposure step or an ozone exposure step (40) after the step of forming (322) the doped HZO layer (132) and before the step of forming (323) the niobium oxide layer (133).

13. The method (30) according to claim 11 or 12, wherein at least one of the titanium oxide layer (131), the first electrode (11), and the second electrode (12), is formed by atomic layer deposition.

14. The method (30) according to one of the claims 11 to 13, wherein the titanium oxide layer (131) is formed by atomic layer deposition using titanium methoxide and water.

15. The method (30) according to one of the claims 11 to 14, further comprising an anneal step at a temperature above 375°C after the step of forming (33) the second electrode (12).
